# EUROPEAN PATENT APPLICATION

(11) **EP 4 586 316 A1**
(43) Date of publication of application: **16.07.2025**
(21) Application number: 24204621.7
(22) Date of filing: 04.10.2024
(51) Int. Cl.: H01L 25/065, H01L 25/18

(54) **SEMICONDUCTOR PACKAGE WITH MEMORY STACKS AND BUFFER CHIPS**

(30) Priority: 12.01.2024 KR 20240005574
(71) Applicant: Samsung Electronics Co., Ltd, Suwon-si, Gyeonggi-do 16677 (KR)
(72) Inventor: SEO, Jungmin, 16677 Suwon-si, Gyeonggi-do (KR); SONG, Kiwhan, 16677 Suwon-si, Gyeonggi-do (KR)
(74) Representative: Kuhnen & Wacker Patent- und Rechtsanwaltsbüro PartG mbB

(57) **Abstract**

A semiconductor package, including: a package substrate (100); a chip unit (200) including a first semiconductor chip (200-1) and a second semiconductor chip (200-2); a first chip stack structure (300) and a second chip stack structure (400), wherein the first semiconductor chip (200-1) includes a first chip body (210-1), a left first chip pad (210-1), and a right first chip pad (220-1), wherein the second semiconductor chip (200-2) includes a second chip body (210-2), a left second chip pad (220-2), and a right second chip pad (230-2), wherein the left first chip pad (210-1) is connected to the first chip stack structure (300), the right second chip pad (230-2) is connected to the second chip stack structure (400), and the right first chip pad (220-1) and the left second chip pad (220-2) are symmetrical and connected to a substrate pad (120) included in the package substrate (100) using a single-point type connection.

## Description

### BACKGROUND

### 1. Field

The present disclosure relates to a semiconductor package, and more particularly, to a semiconductor package having a plurality of buffer chips.

### 2. Description of Related Art

With the rapid development of the electronics industry and demands of users, electronic devices are becoming more compact and lightweight. As electronic devices become smaller and lighter, semiconductor packages used in electronic devices are also becoming smaller and lighter, and semiconductor packages may need to have high reliability along with high performance and large capacity. As the performance and capacity of these semiconductor packages increase, signal transmission paths to the semiconductor packages may become more complex. Accordingly, the importance of the structure of a semiconductor package corresponding to the size and performance of the semiconductor package and ensuring stable signal transmission to the semiconductor package is increasing.

### SUMMARY

Provided is a semiconductor package including buffer chips arranged in a structure capable of minimizing signal interference between wires in a package substrate.

In addition, the problems to be solved by the embodiments of the present disclosure are not limited to the aforementioned problems, and other problems may be clearly understood by those skilled in the art from the following description.

Additional aspects will be set forth in part in the description which follows and, in part, will be apparent from the description, or may be learned by practice of the presented embodiments.

In accordance with an aspect of the disclosure, a semiconductor package includes: a package substrate; a chip unit including a first semiconductor chip on a left portion of the package substrate in a first direction, and a second semiconductor chip disposed on a right portion of the package substrate in the first direction; a first chip stack structure in which a first plurality of memory chips are stacked, wherein the first chip stack structure is leftward of the first semiconductor chip in the first direction and adjacent to the first semiconductor chip on the package substrate; and a second chip stack structure in which a second plurality of memory chips are stacked, wherein the second chip stack structure is rightward of the second semiconductor chip in the first direction and adjacent to the second semiconductor chip on the package substrate, wherein the first semiconductor chip includes a first chip body, a left first chip pad extending in a second direction perpendicular to the first direction along a left edge of an upper surface of the first chip body in the first direction, and a right first chip pad extending along a right edge of the upper surface of the first chip body in the first direction, wherein the second semiconductor chip includes a second chip body, a left second chip pad extending in the second direction along a left edge of an upper surface of the second chip body in the first direction, and a right second chip pad extending in the second direction along a right edge of the upper surface of the second chip body in the first direction, wherein the left first chip pad is connected to the first chip stack structure, and the right first chip pad is connected to a substrate pad included in the package substrate, wherein the left second chip pad is connected to the substrate pad, and the right second chip pad is connected to the second chip stack structure, wherein the right first chip pad is symmetrical to the left second chip pad, and wherein the right first chip pad and the left second chip pad are connected to the substrate pad using a single-point type connection.

In accordance with an aspect of the disclosure, a semiconductor package includes: a package substrate; a first buffer chip on the package substrate, wherein an upper surface of the first buffer chip has a rectangular shape; a second buffer chip rightward of the first buffer chip in a first direction and adjacent to the first buffer chip on the package substrate, wherein an upper surface of the second buffer chip has the rectangular shape; a first chip stack structure in which a first plurality of memory chips are stacked, wherein the first chip stack structure is leftward of the first buffer chip in the first direction and adjacent to the first buffer chip on the package substrate; and a second chip stack structure in which a second plurality of memory chips are stacked, wherein the second chip stack structure is disposed rightward of the second buffer chip in the first direction and adjacent to the second buffer chip on the package substrate, and wherein the first buffer chip includes a left first chip pad extending a second direction perpendicular to the first direction along a left edge of the upper surface of the first buffer chip in the first direction, and a right first chip pad extending in the second direction along a right edge of the upper surface of the first buffer chip in the first direction, wherein the second buffer chip includes a left second chip pad extending in the second direction along a left edge of the upper surface of the second buffer chip in the first direction, and a right second chip pad extending in the second direction along a right edge of the upper surface of the second buffer chip in the first direction, and wherein the right first chip pad is point symmetrical to the left second chip pad.

In accordance with an aspect of the disclosure, a semiconductor package includes: a first package substrate; an internal semiconductor package on the first package substrate; and a controller chip adjacent to the internal semiconductor package on the first package substrate, wherein the internal semiconductor package includes: a second package substrate; a chip unit including a first semiconductor chip on a left portion of the second package substrate in a first direction and a second semiconductor chip on a right portion of the second package substrate in the first direction; a first chip stack structure in which a first plurality of memory chips are stacked, wherein the first chip stack structure is disposed leftward of the first semiconductor chip in the first direction and adjacent to the first semiconductor chip on the second package substrate; a second chip stack structure in which a second plurality of memory chips are stacked, the second chip stack structure being disposed rightward of the second semiconductor chip in the first direction and to the second semiconductor chip on the second package substrate; and an external connection terminal on a lower surface of the second package substrate, wherein each semiconductor chip from among the first semiconductor chip and the second semiconductor chip includes: a chip body, a left chip pad extending in a second direction perpendicular to the first direction along a left edge of an upper surface of the chip body in the first direction, and a right chip pad extending in the second direction along a right edge of the upper surface of the chip body, wherein the right chip pad of the first semiconductor chip is symmetrical to the left chip pad of the second semiconductor chip, and wherein the right chip pad of the first semiconductor chip and the left chip pad of the second semiconductor chip are commonly connected to a substrate pad of the second package substrate using a single-point type connection.

### BRIEF DESCRIPTION OF DRAWINGS

The above and other aspects, features, and advantages of certain embodiments of the present disclosure will be more apparent from the following description taken in conjunction with the accompanying drawings in which:
FIG. 1A is a plan view schematically showing a semiconductor package including buffer chips, according to an embodiment;
FIG. 1B is a cross-sectional view schematically showing a semiconductor package including buffer chips, according to an embodiment;
FIG. 2A is a plan view showing a first buffer chip and a second buffer chip for explaining the symmetrical structure of chip pads in the semiconductor package of FIG. 1A, according to an embodiment;
FIG. 2B illustrates an enlarged plan view of the first buffer chip, in the semiconductor package of FIG. 1A, according to an embodiment;
FIG. 2C illustrates an enlarged plan view of the second buffer chip in the semiconductor package of FIG. 1A, according to an embodiment;
FIG. 3A is a plan view schematically showing a semiconductor package including buffer chips according to a comparative example;
FIG. 3B is a cross-sectional view schematically showing a semiconductor package including buffer chips according to a comparative example;
FIGS. 4A and 4B are conceptual diagrams for explaining signal interference within a package substrate in the semiconductor package according to the comparative example and the semiconductor package according to an embodiment;
FIG. 5A is a cross-sectional view schematically showing a semiconductor package including buffer chips, according to an embodiment;
FIG. 5B is a plan view of a first buffer chip and a second buffer chip for explaining a symmetrical structure of chip pads, according to an embodiment;
FIGS. 6A to 6C are cross-sectional views and a plan view schematically showing semiconductor packages including buffer chips, according to embodiments;
FIG. 7A is a cross-sectional view schematically showing a semiconductor package including buffer chips, according to an embodiment;
FIG. 7B is a magnified plan view of a first semiconductor chip of the buffer chips, according to an embodiment;
FIG. 8A is a plan view schematically showing a semiconductor package device including buffer chips, according to an embodiment; and
FIG. 8B is a cross-sectional view schematically showing a semiconductor package device including buffer chips, according to an embodiment.

### DETAILED DESCRIPTION

Embodiments will now be described more fully with reference to the accompanying drawings. In the accompanying drawings, like reference numerals may refer to like elements, and repeated, redundant, or duplicative descriptions of such elements may be omitted.

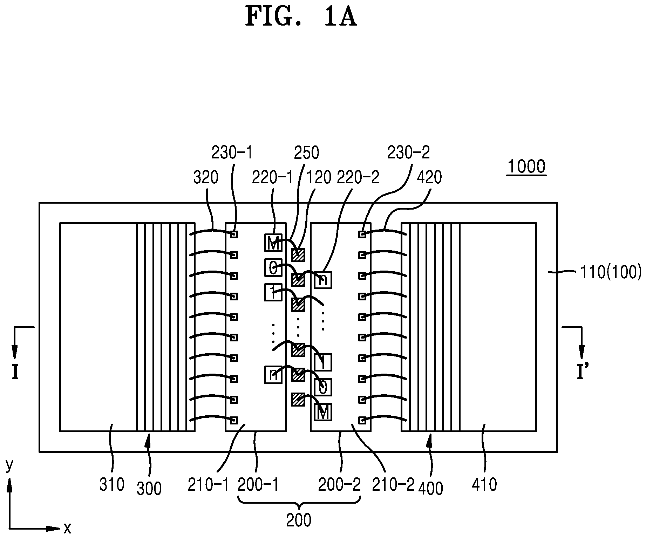

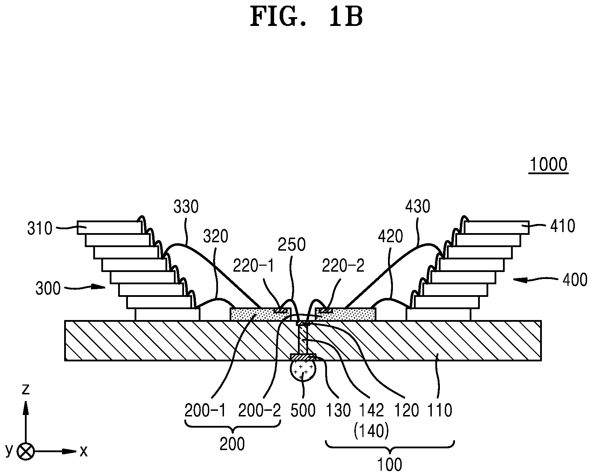

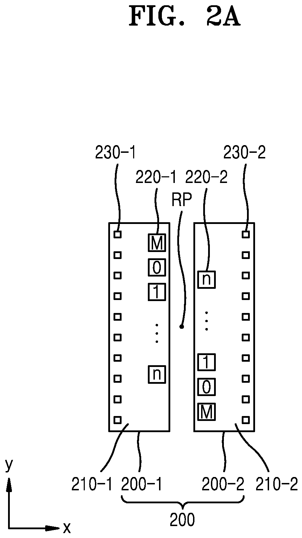

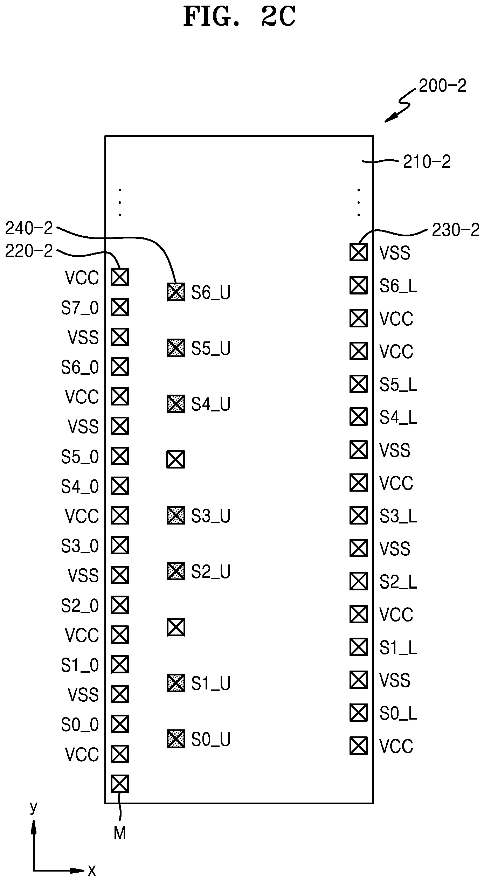

FIGS. 1A and 1B are a plan view and a cross-sectional view schematically showing a semiconductor package including buffer chips according to an embodiment. FIG. 1B is a cross-sectional view taken along line I-I' of FIG. 1A. FIGS. 2A through 2C are a plan view of a first buffer chip and a second buffer chip for explaining the symmetrical structure of chip pads, and enlarged plan views of the first buffer chip and the second buffer chip, in the semiconductor package of FIG. 1A.

Referring to FIGS. 1A through 2C, a semiconductor package 1000 including buffer chips according to embodiments (which may be referred to as a semiconductor package) may include a package substrate 100, a chip unit 200, a first chip stack structure 300, a second chip stack structure 400, and an external connection terminal 500.

The package substrate 100 may be disposed below the chip unit 200, the first chip stack structure 300, and the second chip stack structure 400 in a vertical direction (e.g., a Z-direction), and may support the chip unit 200, the first chip stack structure 300, and the second chip stack structure 400. In the semiconductor package 1000 according to embodiments, the package substrate 100 may be, for example, a printed circuit board (PCB). However, according to embodiments, the package substrate 100 is not limited to a PCB.

The package substrate 100 may include a substrate body 110, a substrate wiring layer 140, an upper substrate pad 120, and a lower substrate pad 130. The substrate body 110 may include, for example, glass fiber and resin such as FR4. However, according to embodiments, the material of the substrate body 110 is not limited thereto. For example, the substrate body 110 may include Bismaleimide-Triazine (BT) resin, poly carbonate (PC) resin, build up films (e.g., an Ajinomoto build-up film (ABF)), or other laminate resin.

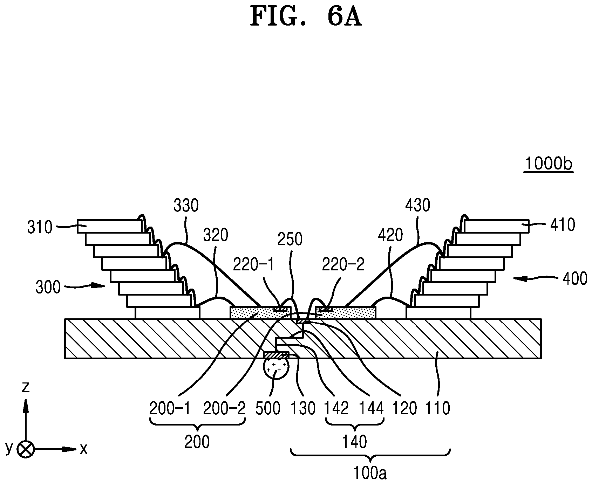

The substrate wiring layer 140 may be arranged within the substrate body 110. The substrate wiring layer 140 may include an internal wire (e.g., internal wire 144 in FIG. 6A) and a vertical via 142. For example, the substrate wiring layer 140 may include several layers of the internal wires 144, for example eight to twenty layers of the internal wires 144. However, according to embodiments, the number of layers of the internal wires 144 is not limited thereto. In some embodiments, internal wires 144 of different layers may be connected to each other using a vertical via 142.

The upper substrate pad 120 may be disposed on an upper surface of the package substrate 100, for example, on an upper surface of the substrate body 110. As shown in FIG. 1A, the upper substrate pad 120 may be interposed between a first semiconductor chip 200-1 and a second semiconductor chip 200-2 in a first horizontal direction (e.g., an X-direction) and may extend in a second horizontal direction (e.g., a Y-direction). Chip pads of the first semiconductor chip 200-1 and the second semiconductor chip 200-2 may be commonly connected to the upper substrate pad 120 using a single-point type connection. An example of the single-point type common connection structure to the upper substrate pad 120 is described in more detail below with reference to the chip unit 200.

The lower substrate pad 130 may be disposed on a lower surface of the package substrate 100 in the Z-direction, for example, on a lower surface of the substrate body 110 in the Z-direction. An external connection terminal 500 may be disposed on the lower substrate pad 130. As shown in FIG. 1B, the lower substrate pad 130 and the external connection terminal 500 connected thereto may be disposed on the lower surface of the package substrate 100. However, embodiments are not limited thereto. For example, in some embodiments, the lower substrate pad 130 and the external connection terminal 500 may be arranged in one row or a plurality of rows in a Y-direction on the lower surface of the package substrate 100. According to some embodiments, the lower substrate pad 130 and the external connection terminal 500 may be arranged in a two-dimensional (2D) array structure on the lower surface of the package substrate 100.

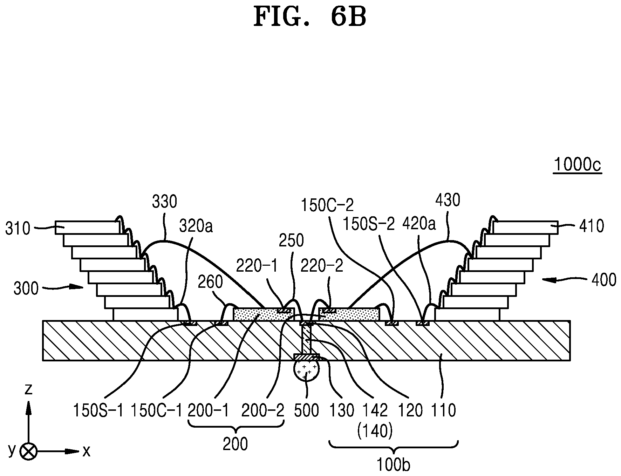

In the semiconductor package 1000 according to embodiments, the upper substrate pad 120 and the lower substrate pad 130 may be connected to each other through the vertical via 142. For example, the vertical via 142 may extend in the vertical direction (e.g., the Z-direction), while having a structure that penetrates the substrate body 110, an upper surface of the vertical via 142 may be connected to the upper substrate pad 120, and a lower surface of the vertical via 142 may be connected to the lower substrate pad 130. However, according to embodiments, a connection between the upper substrate pad 120 and the lower substrate pad 130 is not limited to connection through the vertical via 142. For example, the upper substrate pad 120 and the lower substrate pad 130 may be connected to each other through the vertical via 142 and the internal wires 144. Examples of a connection structure between the upper substrate pad 120 and the lower substrate pad 130 through the vertical via 142 and the internal wire 144 are described in more detail with reference to FIGS. 6A and 6B.

In some embodiments, the package substrate 100 may include a protective layer. The protective layer may protect the substrate body 110 and the substrate wiring layer 140 from external physical and chemical damage. The protective layer may include an upper protective layer on the upper surface of the substrate body 110 and a lower protective layer on the lower surface of the substrate body 110. The protective layer may include, for example, solder resist (SR). However, according to embodiments, the material of the protective layer is not limited to the SR.

The chip unit 200 may be mounted on the package substrate 100, and may include the first semiconductor chip 200-1 and the second semiconductor chip 200-2. The first semiconductor chip 200-1 and the second semiconductor chip 200-2 may have substantially the same structure, except that they may be disposed in a point-symmetric structure on the package substrate 100. For example, as shown in FIG. 2A, the first semiconductor chip 200-1 and the second semiconductor chip 200-2 may form a point-symmetric structure with respect to a reference point RP. Accordingly, when the second semiconductor chip 200-2 is rotated 180°, integrated circuits, internal wires, and chip pads of the second semiconductor chip 200-2 may be consistent with integrated circuits, internal wires, and chip pads of the first semiconductor chip 200-1. Hereinafter, an example of the first semiconductor chip 200-1 is provided below. According to embodiments, a substantially similar description may be applied to the second semiconductor chip 200-2, in consideration of the point-symmetric structure.

In some embodiments first semiconductor chip 200-1 may be stacked on the package substrate 100 using an adhesive layer. The adhesive layer may be, for example, a die attach film (DAF). However, according to embodiments, the adhesive layer is not limited to the DAF.

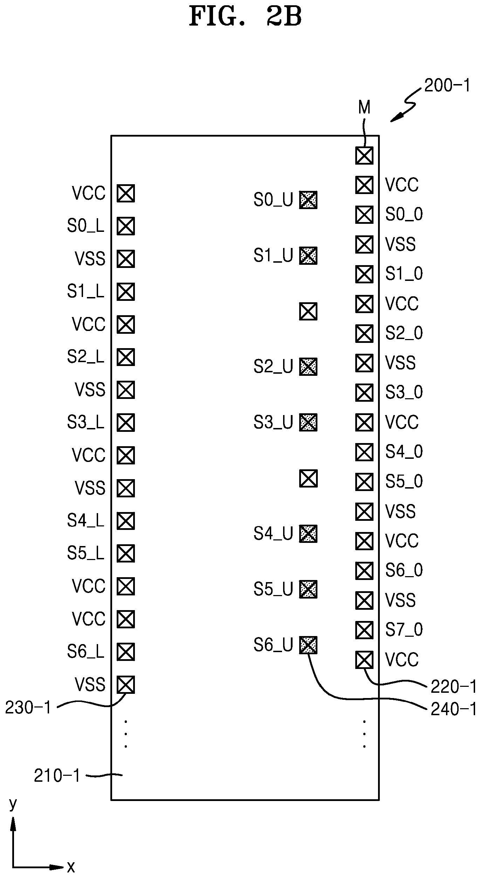

The first semiconductor chip 200-1 may include a first chip body 210-1, a right first chip pad 220-1, a left first chip pad 230-1, and a central first chip pad 240-1. For convenience of illustration , the central first chip pad 240-1 is omitted from FIGS. 1A and 2A. According to some embodiments, the first chip stack structure 300 may have one channel, and accordingly, the central first chip pad 240-1 may be omitted. In FIG. 2A, an example is illustrated in which the right first chip pad 220-1 is a relatively larger size than the left first chip pad 230-1. However, this is only for convenience of description, and embodiments are not limited thereto. For example as shown in FIG. 2B, the right first chip pad 220-1 and the left first chip pad 230-1 may have substantially the same size.

The first chip body 210-1 may form the body of the first semiconductor chip 200-1. An upper surface of the first chip body 210-1 may have a rectangular shape that extends in one direction, for example, the Y-direction. However, according to embodiments, the shape of the first chip body 210-1 is not limited thereto. For example, according to some embodiments, the upper surface of the first chip body 210-1 may have a shape close to a square.

The first chip body 210-1 may include a substrate and an active layer. The substrate may include silicon (Si), such as single crystalline Si, polycrystalline Si, or amorphous Si. However, according to embodiments, a material of the substrate is not limited to Si. For example, in some embodiments, the substrate may include a group IV semiconductor (such as, germanium (Ge)), a groups IV-IV elements-containing compound semiconductor (such as, silicon germanium (SiGe) or silicon carbide (SiC)), or a group III-V elements-containing compound semiconductor (such as, gallium arsenide (GaAs), indium arsenide (InAs), or indium phosphide (InP)).

The substrate may be based on a Si bulk substrate. The substrate may be based on a silicon on insulator (SOI) substrate or a germanium-on-insulator (GeOI) substrate. However, according to embodiments, a material of the substrate is not limited to a bulk, SOI, or GeOI substrate, but may also be a substrate based on an epitaxial wafer, a polished wafer, or an annealed wafer.

The active layer may include an integrated circuit layer and multiple wiring layers. The integrated circuit layer may include an integrated circuit formed using an impurity region of an upper portion of the substrate. For example, the integrated circuit layer may include transistors composed of an impurity region, such as a source/drain region, and a gate electrode. However, according to embodiments, the integrated circuit included in the integrated circuit layer is not limited to the transistors. The multiple wiring layer may be disposed over the integrated circuit layer and may include multiple layers of internal wires. The internal wires may be electrically connected to the integrated circuit layer through contacts. In the multiple wiring layers, internal wires of different layers may be connected to each other through vertical vias. Hereinafter, for convenience, the integrated circuit and the internal wires may be collectively referred to as an internal circuit.

In some embodiments, an upper surface of the active layer may correspond to an active surface, and a lower surface of the substrate that is opposite to the active surface may correspond to an inactive surface. In general, the right first chip pad 220-1, the left first chip pad 230-1, and the central first chip pad 240-1 may be disposed on the upper surface of the active layer. A rectangular surface shown in FIG. 1A or 2A may correspond to the upper surface of the first chip body 210-1 and also the upper surface of the active layer. In some embodiments, a passivation layer, such as an oxide layer, a nitride layer, or an oxynitride layer, may be disposed on the upper surface of the active layer to protect the first semiconductor chip 200-1.

The first semiconductor chip 200-1 according to embodiments may be, for example, a buffer chip, and may include logic elements therein. For example, the buffer chip may be disposed on the package substrate along with a corresponding chip stack structure. The buffer chip may integrate signals from memory chips of the chip stack structure and transmit a result of the integration to the outside, for example, to an outside of the first semiconductor chip 200-1 or an outside of the semiconductor package 1000, and may also transmit signals and power from the outside to the memory chips. For example, in the semiconductor package 1000 according to embodiments, the first semiconductor chip 200-1 may integrate signals from memory chips 310 of the chip stack structure and transmit a result of the integration to the outside, and may also transmit signals and power from the outside to the memory chips 310.

According to some embodiments, the first semiconductor chip 200-1 may be a controller chip. The controller chip may have a similar function as the buffer chip, but may further include a timing controller, a voltage controller, an arithmetic circuit, etc. to optimize the timings or voltages of the signals transmitted to the memory chips 310. In general, a buffer chip may be included in a solid state driver (SSD) package, and a controller chip may be included in a universal flash storage (UFS) package. For convenience, a case where the first semiconductor chip 200-1 is a buffer chip will now be described.

The right first chip pad 220-1 may be disposed on a right edge of the upper surface of the first chip body 210-1. For example, when the upper surface of the first chip body 210-1 has a rectangular shape extending in the Y-direction, pads included in the right first chip pad 220-1 may extend, in the Y-direction, along a right edge of the first chip body 210-1 in the X-direction. The right first chip pad 220-1 may include a plurality of signal pads (e.g., signal pad S0_0 through signal pad S7_0), as well as power pads VCC and ground pads VSS. The plurality of signal pads may refer to pads for transmitting signals, such as read, write, and erase signals, to the memory chips 310 of the first chip stack structure 300. The power pads VCC may refer to pads that provide a power voltage to the memory chips 310 of the first chip stack structure 300, and ground pads VSS may refer to pads that provide a ground voltage to the memory chips 310 of the first chip stack structure 300.

The right first chip pad 220-1 may include a mirror pad M at a top of the right first chip pad 220-1 in the Y-direction. However, according to embodiments, the location of the mirror pad M is not limited thereto. In the semiconductor package 1000 according to embodiments, a connection of the signal pads of the right first chip pad 220-1 to the internal circuit may be swapped according to a signal applied to the mirror pad M. For example, when a signal of '0' is applied to the mirror pad M, signal pads 0, 1, ..., and n (e.g., the signal pads S0_0, S1_0, ..., and S7_0 of FIG. 2B) may be connected to the internal circuit in the Y-direction order shown in FIGS. 2A and 2B. However, when a signal of '1', which may be for example a swap enable signal, is applied to the mirror pad M, the signal pads 0, 1, ..., and n (e.g., the signal pads S0_0, S1_0, ..., and S7_0 of FIG. 2B) may be connected to the internal circuit in a reverse order in the Y-direction.

For example, the first semiconductor chip 200-1 and the second semiconductor chip 200-2 may have internal circuits having substantially the same structures, as described above. Therefore, as the second semiconductor chip 200-2 is rotated 180° and disposed on the package substrate 100, the internal circuits of the first semiconductor chip 200-1 and the second semiconductor chip 200-2 may have point-symmetrical structures with respect to each other. However, when a swap enable signal of '1' is applied to the mirror pad M of the second semiconductor chip 200-2 and a connection between a signal pad and an internal circuit is swapped, an internal circuit of the first semiconductor chip 200-1 that is connected to the signal pad 0 of the first semiconductor chip 200-1 may be substantially the same as an internal circuit of the second semiconductor chip 200-2 that is connected to the signal pad n of the second semiconductor chip 200-2. In addition, the signal pad 1 of the first semiconductor chip 200-1 and the signal pad n-1 of the second semiconductor chip 200-2, and the signal pad 2 of the first semiconductor chip 200-1 and the signal pad n-2 of the semiconductor chip 200-2, etc., may also be connected to the same corresponding internal circuit. Accordingly, the signal pad 0 of the first semiconductor chip 200-1 and the signal pad n of the second semiconductor chip 200-2 may receive the same signals. Likewise, the signal pad 1 of the first semiconductor chip 200-1 and the signal pad n-1 of the second semiconductor chip 200-2 may receive the same signals, and the signal pad 2 of the first semiconductor chip 200-1 and the signal pad n-2 of the semiconductor chip 200-2 may receive the same signals.

As a result, in the semiconductor package 1000 according to embodiments, as shown in FIG. 1A, the right first chip pad 220-1 and the left second chip pad 220-2 may be connected to the upper substrate pad 120 of the package substrate 100 through a third wire 250 and may have a single-point type connection structure to the upper substrate pad 120. For example, the signal pad 0 of the right first chip pad 220-1 and the signal pad n of the left second chip pad 220-2 may be commonly connected to an upper substrate pad 120 positioned second from the top in the Y-direction, through the third wire 250. Therefore, the upper substrate pad 120 positioned second may correspond to a single-point type connection contact between the signal pad 0 of the right first chip pad 220-1 and the signal pad n of the left second chip pad 220-2. In addition, the signal pad 1 of the right first chip pad 220-1, the signal pad n-1 of the left second chip pad 220-2, the signal pad 2 of the right first chip pad 220-1, and the signal pad n-2 of the left second chip pad 220-2 may be commonly connected to the corresponding upper substrate pads 120, respectively, through the third wire 250, and may have a single-point type connection structure.

The left first chip pad 230-1 may be disposed on a left edge of the upper surface of the first chip body 210-1. For example, when the upper surface of the first chip body 210-1 has a rectangular shape extending in the Y-direction, pads included in the left first chip pad 230-1 may extend, in the Y-direction, along a left edge of the first chip body 210-1 in the X-direction. The left first chip pad 230-1 may also include a plurality of signal pads (e.g., signal pad S0_L through signal pad S6_L), as well as power pads VCC and ground pads VSS. The left first chip pad 230-1 may be connected to the memory chips 310 disposed in the first chip stack structure 300 in the Z-direction. For example, the left first chip pad 230-1 may be connected to a lowermost memory chip 310 of the first chip stack structure 300 in the Z-direction through the first wire 320. According to some embodiments, the signal pads of the left first chip pad 230-1 may be referred to as signal pads for a lower channel.

The central first chip pad 240-1 may be disposed in the Y-direction between both edges on the upper surface of the first chip body 210-1 in the X-direction. The central first chip pad 240-1 may extend in the Y-direction on the upper surface of the first chip body 210-1 with a bias toward one edge in the X-direction, for example, a right edge as shown in FIG. 2B. However, according to embodiments, the central first chip pad 240-1 may extend in the Y-direction with a bias toward a left edge in the X-direction, or may extend in the Y-direction on an upper surface of an exact center portion of the first chip body 210-1 in the X-direction.

The central first chip pad 240-1 may include a plurality of signal pads (e.g., signal pad S0_U through signal pad S6_U). The central first chip pad 240-1 may be connected to the memory chips 310 disposed at an upper portion of the first chip stack structure 300 in the Z-direction. For example, the central first chip pad 240-1 may be connected to a memory chip 310 positioned fifth from the bottom in the Z-direction in the first chip stack structure 300 through the second wire 330. According to some embodiments, the signal pads of the central first chip pad 240-1 may be referred to as a signal pads for an upper channel.

The first chip stack structure 300 and the second chip stack structure 400 may have substantially the same structures except that they may have opposite staircase structures in the X-direction. For example, the first chip stack structure 300 may include memory chips 310 stacked on the package substrate 100 in a staircase structure along a negative (-)X-direction, and the second chip stack structure 400 may include memory chips 410 stacked on the package substrate 100 in a staircase structure along a positive (+)X-direction. The staircase structure along the negative (-)X-direction may refer to a structure in which locations of the memory chips 310 move leftward in the X-direction as they approach the top in the Z-direction, and the staircase structure along the positive (+)X-direction may refer to a structure in which locations of the memory chips 410 move rightward in the X-direction as they approach the top in the Z-direction. An example description of the first chip stack structure 300 is provided below.

As shown in FIG. 1B, the first chip stack structure 300 may include a plurality of memory chips 310 stacked in the vertical direction (e.g., the Z-direction), on the package substrate 100. In the semiconductor package 1000 according to embodiments, each of the memory chips 310 of the first chip stack structure 300 may be a flash memory chip, for example, a NAND flash memory chip. However, according to embodiments, the type of memory chip 310 is not limited to a flash memory chip. For example, the memory chip 310 may include other types of non-volatile memory chips, or volatile memory chips such as a dynamic random access memory (DRAM) chip.

As shown in FIG. 1B, in the first chip stack structure 300, memory chips 310 may be stacked in a staircase structure. For example, the first chip stack structure 300 may have a staircase structure along the negative (-)X-direction in which locations of the memory chips 310 move leftward in the X-direction as they approach the top in the Z-direction. In the semiconductor package 1000 according to embodiments, the first chip stack structure 300 may include eight memory chips 310. However, according to embodiments, the number of memory chips 310 included in the first chip stack structure 300 is not limited to eight. For example, the first chip stack structure 300 may include seven or fewer memory chips 310, or nine or more memory chips 310.

In some embodiments, in the first chip stack structure 300, the eight memory chips 310 may be divided into lower memory chips, including four memory chips 310 arranged in a lower portion, and upper memory chips, including four memory chips 310 arranged in an upper portion. The lower memory chips may exchange signals through a lower channel. For example, the lower memory chips may exchange signals through the first wire 320 and the left first chip pad 230-1. The upper memory chips may exchange signals through an upper channel. For example, the upper memory chips may exchange signals through the second wire 330 and the central first chip pad 240-1.

In some embodiments, each of the memory chips 310 may be stacked on the package substrate 100 using an adhesive layer, or on a memory chip 310 immediately below each of the memory chips 310 via an adhesive layer. The adhesive layer may be, for example, a DAF. However, according to embodiments, the material of the adhesive layer is not limited to a DAF.

An example of a connection relationship between the first semiconductor chip 200-1, the memory chips 310 of the first chip stack structure 300, and the package substrate 100 through the third, second, and first wires 250, 330, and 320 may be generally described as follows. The right first chip pad 220-1 of the first semiconductor chip 200-1 may be connected to the upper substrate pad 120 of the package substrate 100 through the third wire 250. The left first chip pad 230-1 of the first semiconductor chip 200-1 may be connected to the lower memory chips, for example, the lowermost memory chip 310, through the first wire 320. The central first chip pad 240-1 of the first semiconductor chip 200-1 may be connected to the upper memory chips, for example, the memory chip 310 positioned fifth from the package substrate 100, through the second wire 330. In the cross-sectional view of FIG. 1B, for convenience, only the right first chip pad 220-1 is illustrated. The same arrangement is applied to the following cross-sectional views.

In some embodiments, the semiconductor package 1000 according to embodiments may include a sealing material. The sealing material may cover and seal the chip unit 200, the first chip stack structure 300, the second chip stack structure 400, and the wires 250, 320, 330, 420, and 430 on the package substrate 100. The sealing material may seal the first semiconductor chip 200-1 and the second semiconductor chip 200-2 of the chip unit 200, the memory chips 310 of the first chip stack structure 300, and the memory chips 410 of the second chip stack structure 400 to protect from external physical and chemical damage. The sealing material may include an insulating material, for example, a thermosetting resin (e.g., an epoxy resin), or a thermoplastic resin (e.g., polyimide). The sealing material may include a resin, for example, ABF, FR-4, or BT resin, obtained by including a reinforcing material, such as an inorganic filler, in a thermosetting resin or thermoplastic resin. The sealing material may also include a molding material, such as an epoxy molding compound (EMC), or a photosensitive material, such as a photo imageable encapsulant (PIE). In the semiconductor package 1000 according to embodiments, the sealing material may include, for example, an EMC. However, according to embodiments, the material of the sealing material is not limited to the above-mentioned materials.

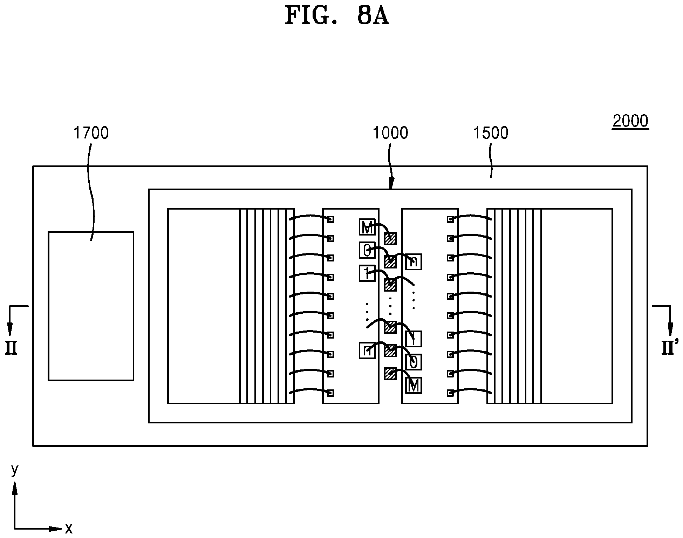

The external connection terminal 500 may be disposed on the lower surface of the package substrate 100 in the Z-direction. For example, the external connection terminal 500 may be disposed on the lower substrate pad 130 on the lower surface of the package substrate 100. The external connection terminal 500 may be electrically connected to the vertical via 142 or the internal wire 144 of the package substrate 100 through the lower substrate pad 130. The external connection terminal 500 may include one or more solder balls. However, according to an embodiment, the external connection terminal 500 may include a pillar and a solder. The semiconductor package 1000 according to embodiments may be mounted on an external package substrate 1500 (as shown for example in FIG. 8A), such as an interposer or a base substrate, through the external connection terminal 500.

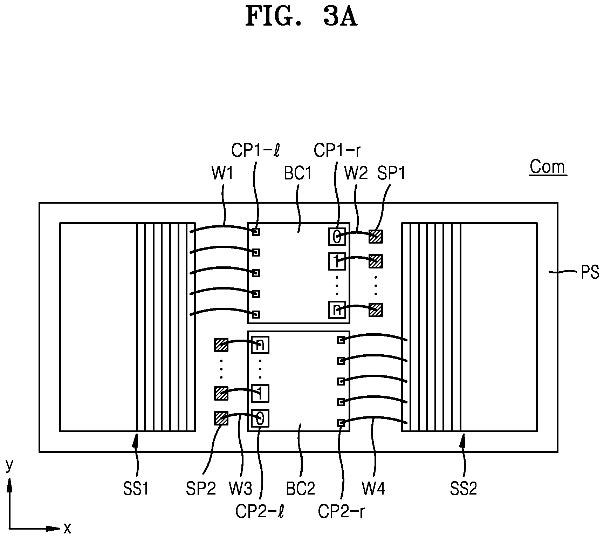

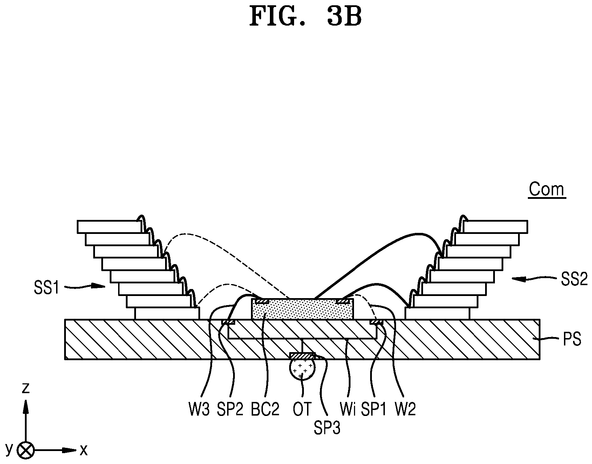

In the semiconductor package 1000 according to embodiments, the first semiconductor chip 200-1 and the second semiconductor chip 200-2 of the chip unit 200 may be arranged in a point-symmetrical structure on the package substrate 100. In addition, the right first chip pad 220-1 of the first semiconductor chip 200-1 and the left second chip pad 220-2 of the second semiconductor chip 200-2 may each include the mirror pad M, and the connection order between a signal pad and an internal circuit may be swapped according to signals applied to the mirror pads M. Accordingly, the right first chip pad 220-1 of the first semiconductor chip 200-1 and the left second chip pad 220-2 of the second semiconductor chip 200-2 may have a single-point type connection structure to the upper substrate pad 120 of the package substrate 100. In addition, based on this single-point type common connection structure, signal interference between internal wires in the package substrate 100 may be minimized, thereby improving the signal integrity (SI) characteristics of a semiconductor package. Examples of interference between the internal wires in the package substrate 100 based on the single-point type common connection structure are described in more detail below with reference to FIGS. 3A and 3B.

FIGS. 3A and 3B are a plan view and a cross-sectional view, respectively, schematically showing a semiconductor package Com including buffer chips according to a comparative example.

Referring to FIGS. 3A and 3B, in the semiconductor package Com according to the comparative example, a first buffer chip BC1 and a second buffer chip BC2 may be arranged adjacent to each other in the Y-direction on a package substrate PS. The first buffer chip BC1 may include a left first chip pad CP1-ℓ and a right first chip pad CP1-r, the left first chip pad CP1-ℓ may be connected to a first chip stack structure SS1 through a first wire W 1, and the right first chip pad CP1-r may be connected to a first substrate pad SP1 on the right side of the first buffer chip BC1 through a second wire W2. The second buffer chip BC2 may include a left second chip pad CP2-E and a right second chip pad CP2-r, the left second chip pad CP2-f may be connected to a second substrate pad SP2 on the left side of the second buffer chip BC2 through a third wire W3, and the right second chip pad CP2-r may be connected to a second chip stack structure SS2 through a fourth wire W4.

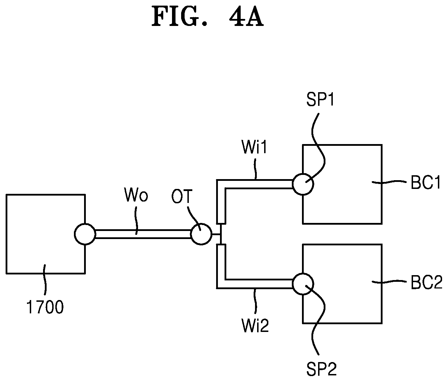

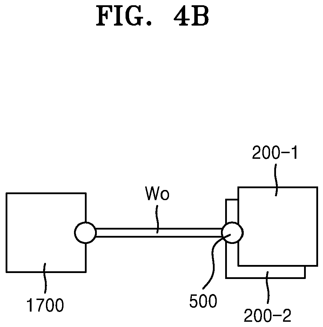

Based on a connection relationship between the first buffer chip BC1, the second buffer chip BC2, and the package substrate PS, the first substrate pad SP1 and the second substrate pad SP2 may be connected to an external connection terminal OT on a third substrate pad SP3 through an internal wire Wi. In some embodiments, as shown for example in FIG. 3B, the internal wire Wi connected to the third substrate pad SP3 may be branched and connect to the first substrate pad SP1 and the second substrate pad SP2. Accordingly, signal interference may occur between the branched internal wires Wi, thereby deteriorating signal characteristics, such as SI characteristics. Signal interference will now be described in more detail in the description of FIGS. 4A and 4B.

FIGS. 4A and 4B are conceptual diagrams for explaining signal interference within a package substrate in the semiconductor package Com according to the comparative example and the semiconductor package 1000 according to embodiments. FIG. 4A conceptually illustrates a wiring connection relationship between a package substrate and a controller chip in the semiconductor package Com according to the comparative example, and FIG. 4B conceptually illustrates a wiring connection relationship between a package substrate and a controller chip in the semiconductor package 1000 according to embodiments.

Referring to FIG. 4A, in the semiconductor package Com according to the comparative example, the first buffer chip BC1 may be connected to the first substrate pad SP1, and the second buffer chip BC2 may be connected to the second substrate pad SP2. The first substrate pad SP1 may be connected to the external connection terminal OT through a first internal wire Wi1, and the second substrate pad SP2 may be connected to the external connection terminal OT through a second internal wire Wi2. Accordingly, signal interference may occur between the first internal wire Wi1 and the second internal wire Wi2 within the package substrate PS, and the SI characteristics of the semiconductor package Com according to the comparative example may deteriorate. The signal interference may also be referred to as signal reflection, crosstalk, etc.

Referring to FIG. 4B, in the case of the semiconductor package 1000 according to embodiments, the first semiconductor chip 200-1 and the second semiconductor chip 200-2 may have a single-point type connection structure and may be connected to the upper substrate pad 120, and the upper substrate pad 120 may be connected to the external connection terminal 500 through the vertical via 142 of a single path, or through the vertical via 142 and the internal wire 144 of a single path. Accordingly, signal interference within the package substrate 100 may be minimized, and SI characteristics of the semiconductor package 1000 may be improved.

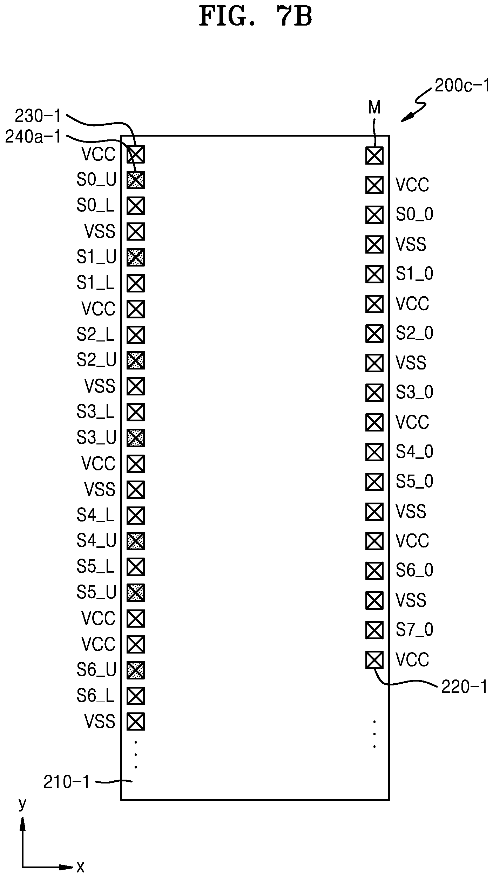

For reference, in FIGS. 4A and 4B, wiring between the external connection terminal 500 and a controller chip 1700 is an external wire Wo, and may be included in a wiring 1520 (as shown for example in FIG. 7B) of the external package substrate 1500 (as shown for example in FIG. 7B). The external wire Wo may have substantially the same structure and substantially the same length, in the semiconductor package Com according to the comparative example and the semiconductor package 1000 according to embodiments. Accordingly, a portion of the external wire Wo may not significantly affect a difference in signal characteristics between the semiconductor package Com according to the comparative example and the semiconductor package 1000 according to embodiments.

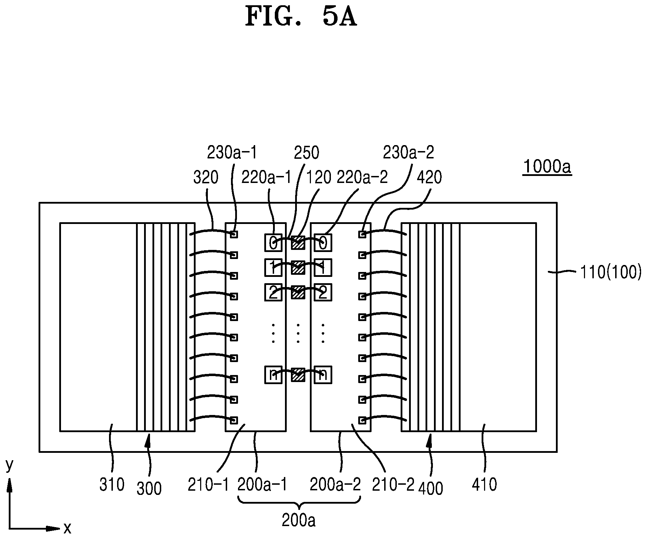

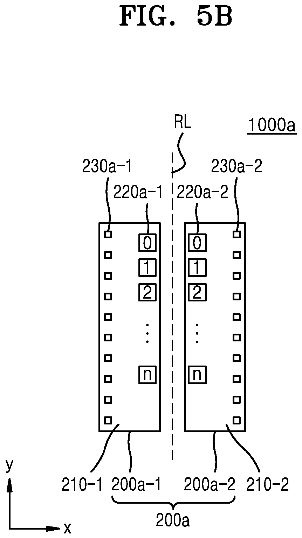

FIGS. 5A and 5B are a plan view schematically showing a semiconductor package 1000a including buffer chips according to an embodiment, and a plan view of a first buffer chip and a second buffer chip for explaining a symmetrical structure of chip pads, respectively. Descriptions of FIGS. 5A and 5B which are redundant or duplicative of description given above with reference to FIGS. 1A through 4B may given briefly or omitted below.

Referring to FIGS. 5A and 5B, the semiconductor package 1000a according to embodiments may differ from the semiconductor package 1000 of FIG. 1A by including a chip unit 200a. For example, the semiconductor package 1000a according to embodiments may include the package substrate 100, the chip unit 200a, the first chip stack structure 300, the second chip stack structure 400, and the external connection terminal 500. The package substrate 100, the first chip stack structure 300, the second chip stack structure 400, and the external connection terminal 500 may be the same as those described above with reference to the semiconductor package 1000 of FIG. 1A.

The chip unit 200a may be mounted on the package substrate 100, and may include a first semiconductor chip 200a-1 and a second semiconductor chip 200a-2. The first semiconductor chip 200a-1 and the second semiconductor chip 200a-2 may be arranged adjacent to each other in the X-direction on the package substrate 100, and may have a mirror symmetrical structure with respect to each other. For example, as shown in FIG. 5B, the first semiconductor chip 200a-1 and the second semiconductor chip 200a-2 may be mirror symmetrical with each other about a reference line RL. Accordingly, integrated circuits, internal wires, and chip pads of the first semiconductor chip 200a-1 may achieve mirror symmetry with integrated circuits, internal wires, and chip pads of the second semiconductor chip 200a-2 about the reference line RL.

Describing the chip pads of the first semiconductor chip 200a-1 and the second semiconductor chip 200a-2 in more detail, the first semiconductor chip 200a-1 may include a left first chip pad 230a-1 and a right first chip pad 220a-1, and the second semiconductor chip 200a-2 may include a left second chip pad 220a-2 and a right second chip pad 230a-2. Due to mirror symmetry, the right first chip pad 220a-1 and the left second chip pad 220a-2 may be arranged in the same order in the Y-direction. In addition, signal pads of the right first chip pad 220a-1 may be connected to an internal circuit of the first semiconductor chip 200a-1 in the Y-direction, and signal pads of the left second chip pad 220a-2 may be connected to an internal circuit of the second semiconductor chip 200a-2 in the Y-direction. Accordingly, the right first chip pad 220a-1 and the left second chip pad 220a-2 may include no mirror pads.

Even in the semiconductor package 1000a according to embodiments, as shown in FIG. 5A, the right first chip pad 220a-1 and the left second chip pad 220a-2 may be connected to the upper substrate pad 120 of the package substrate 100 through a third wire 250 and may have a single-point type common connection structure to the upper substrate pad 120. However, unlike the semiconductor package 1000 of FIG. 1A, due to mirror symmetry, a signal pad 0 of the right first chip pad 220a-1 and a signal pad 0 of the left second chip pad 220a-2 may be commonly connected to an upper substrate pad 120 positioned first from the top in the Y-direction through a third wire 250, and a signal pad 1 of the right first chip pad 220a-1 and a signal pad 1 of the left second chip pad 220a-2 are commonly connected to an upper substrate pad 120 positioned second from the top in the Y-direction through the third wire 250. In this way, the right first chip pad 220a-1 and the left second chip pad 220a-2 may have a single-point type common connection structure to the upper substrate pad 120.

According to embodiments, the first semiconductor chip 200a-1 and the second semiconductor chip 200a-2, which may have a mirror symmetrical structure with respect to each other, may be manufactured by performing an exposure process so that two patterns in the X-direction are mirror symmetrical within one shot. The one shot may refer to the area of a pattern that is transferred through one exposure process. Accordingly, in a plurality of exposure processes, two patterns in each shot may be formed to be mirror symmetrical, and two finally manufactured semiconductor chips may be mirror symmetrical to each other.

FIGS. 6A through 6C are cross-sectional views and a plan view schematically showing semiconductor packages including buffer chips, according to embodiments. Descriptions of FIGS. 6A through 6C which are redundant or duplicative of description given above with reference to of FIGS. 1A through 5B may be given briefly or omitted herein.

Referring to FIG. 6A, a semiconductor package 1000b according to embodiments may be different from the semiconductor package 1000 of FIG. 1B in terms of the structure of a package substrate 100a. For example, the semiconductor package 1000b according to embodiments may include the package substrate 100a, the chip unit 200, the first chip stack structure 300, the second chip stack structure 400, and the external connection terminal 500. The chip unit 200, the first chip stack structure 300, the second chip stack structure 400, and the external connection terminal 500 may be the same as those described above with reference to the semiconductor package 1000 of FIG. 1B.

The package substrate 100a may include a substrate body 110, a substrate wiring layer 140, an upper substrate pad 120, and a lower substrate pad 130. The substrate body 110, the substrate wiring layer 140, the upper substrate pad 120, and the lower substrate pad 130 may be the same as those described above with reference to the package substrate 100 of the semiconductor package 1000 of FIG. 1B. However, in the semiconductor package 1000b according to embodiments, the upper substrate pad 120 and the lower substrate pad 130 may be connected to each other through the vertical via 142 and the internal wire 144. For reference, within the package substrate 100a, the vertical via 142 may extend in the vertical direction(e.g., the Z-direction), and the internal wire 144 may extend in a horizontal direction(e.g., at least one of the X-direction and the Y-direction).

In the case of the semiconductor package 1000 of FIG. 1B, as the upper substrate pad 120 and the lower substrate pad 130 are directly connected to each other through the vertical via 142, respective locations of the upper substrate pad 120 and the lower substrate pad 130 may be substantially the same as each other on an x-y plane. However, in the semiconductor package 1000b according to embodiments, as the internal wire 144 is added to the connection between the upper substrate pad 120 and the lower substrate pad 130, the respective locations of the upper substrate pad 120 and the lower substrate pad 130 may be different from each other on the horizontal plane (e.g., the X-Y plane).

Referring to FIG. 6B, a semiconductor package 1000c according to embodiments may be different from the semiconductor package 1000 of FIG. 1B in terms of the structure of a package substrate 100b, a connection structure between the chip unit 200 and the first chip stack structure 300, and a wire connection structure between the chip unit 200 and the second chip stack structure 400. The chip unit 200, the first chip stack structure 300, the second chip stack structure 400, and the external connection terminal 500 in the semiconductor package 1000c according to embodiments may be the same as those described above with reference to the semiconductor package 1000 of FIG. 1B.

The package substrate 100b may further include a first intermediate substrate pad 150C-1, a second intermediate substrate pad 150S-1, a third intermediate substrate pad 150C-2, and a fourth intermediate substrate intermediate substrate pad 150S-2. In addition, the chip unit 200 may be connected to the first chip stack structure 300 using the first intermediate substrate pad 150C-1 and the second intermediate substrate pad 150S-1, and the chip unit 200 may be connected to the second chip stack structure 400 using the third intermediate substrate pad 150C-2 and the fourth intermediate substrate pad 150S-2. For example, the left first chip pad 230-1 of the first semiconductor chip 200-1 may be connected to the first intermediate substrate pad 150C-1 through a fourth wire 260, and a lowermost memory chip 310 of the first chip stack structure 300 in the Z-direction may be connected to the second intermediate substrate pad 150S-1 through a first wire 320a. A right second chip pad 230-2 of the second semiconductor chip 200-2 may be connected to the third intermediate substrate pad 150C-2 through the fourth wire 260, and a lowermost memory chip 410 of the second chip stack structure 400 in the Z-direction may be connected to the fourth intermediate substrate pad 150S-2 through a first wire 420a. Two adjacent intermediate substrate pads, for example, the first intermediate substrate pad 150C-1 and the second intermediate substrate pad 150S-1, or the third intermediate substrate pad 150C-2 and the fourth intermediate substrate pad 150S-2, may be connected to each other through a vertical via 142 and an internal wire 144 of the package substrate 100b. According to an embodiment, the first wire 320a and the fourth wire 260 may be connected together to one intermediate substrate pad, and the first wire 420a and the fourth wire 260 may be connected together to one intermediate substrate pad. In this case, a vertical via and an internal wire connecting two intermediate substrate pads to each other may be omitted.

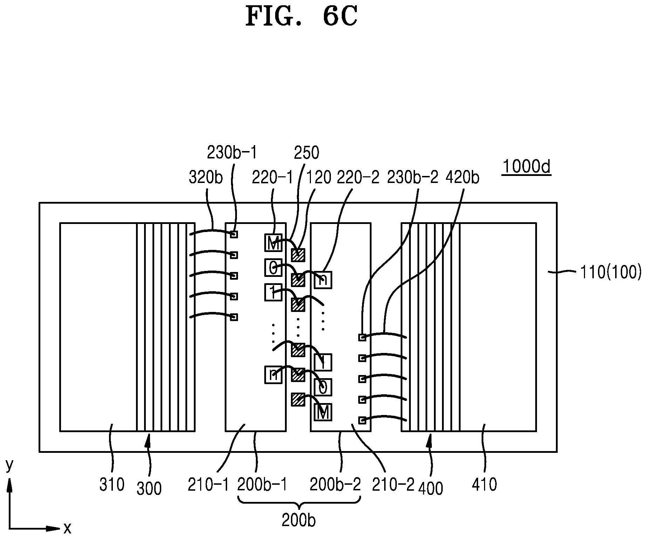

Referring to FIG. 6C, a semiconductor package 1000d according to embodiments may differ from the semiconductor package 1000 of FIG. 1B by including a chip unit 200b, a wire connection structure between the chip unit 200b and the first chip stack structure 300, and a wire connection structure between the chip unit 200b and the second chip stack structure 400. The package substrate 100, the first chip stack structure 300, the second chip stack structure 400, and the external connection terminal 500 of the semiconductor package 1000d according to embodiments may be the same as those described above with reference to the semiconductor package 1000 of FIG. 1B.

The chip unit 200b may include a first semiconductor chip 200b-1 and a second semiconductor chip 200b-2. Left first chip pads 230b-1 of the first semiconductor chip 200b-1 may be disposed to be biased toward an upper side in the Y-direction. Right second chip pads 230b-2 of the second semiconductor chip 200b-2 may be disposed to be biased toward a lower side in the Y-direction. As described above, as the left first chip pads 230b-1 and the right second chip pads 230b-2 are disposed to be biased toward one side in the Y-direction, a wire connection structure between the first chip stack structure 300 and the second chip stack structure 400 may also be disposed to be biased in the Y-direction. For example, the left first chip pads 230b-1 may be connected to a lowermost memory chip 310 of the first chip stack structure 300 in the Z-direction through a first wire 320b, and, as shown in FIG. 6C, the first wire 320b may be disposed to be biased toward an upper side in the Y-direction. The right second chip pads 230b-2 may be connected to a lowermost memory chip 410 of the second chip stack structure 400 in the Z-direction through a first wire 420b, and, as shown in FIG. 6C, the first wire 420b may be disposed to be biased toward a lower side in the Y-direction.

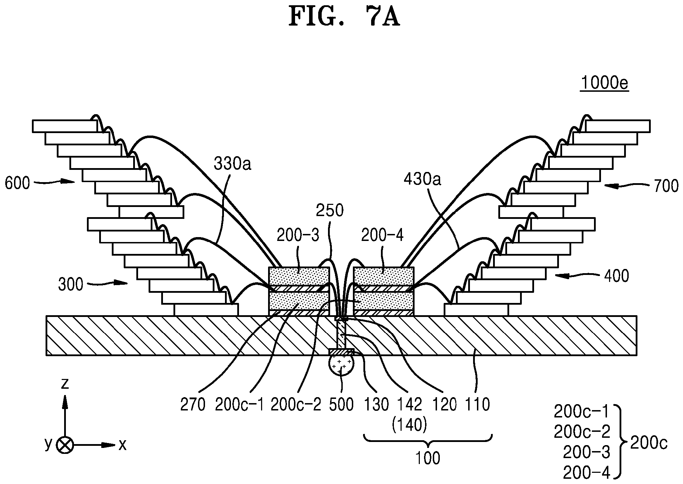

FIG. 7A is a cross-sectional view schematically showing a semiconductor package 1000e including buffer chips, according to an embodiment, and FIG. 7B is a magnified plan view of a first semiconductor chip of the buffer chips, respectively. Descriptions of FIGS. 7A and 7B which are redundant or duplicative of description given above with reference to FIGS. 1A through 6C may be given briefly or omitted herein.

Referring to FIGS. 7A and 7B, the semiconductor package 1000e according to embodiments may further include a third chip stack structure 600 and a fourth chip stack structure 700, in comparison with the semiconductor package 1000 of FIG. 1B. The third chip stack structure 600 may have substantially the same structure as the first chip stack structure 300, and may be stacked on the first chip stack structure 300. The fourth chip stack structure 700 may have substantially the same structure as the second chip stack structure 400, and may be stacked on the second chip stack structure 400.

In the semiconductor package 1000e according to embodiments, a chip unit 200c may further include a third semiconductor chip 200-3 and a fourth semiconductor chip 200-4, in comparison with the chip unit 200 of the semiconductor package 1000 of FIG. 1B. For example, the third semiconductor chip 200-3 may be stacked on the first semiconductor chip 200c-1 using an adhesive layer 270, and the fourth semiconductor chip 200-4 may be stacked on the second semiconductor chip 200c-2 using an adhesive layer 270. The third semiconductor chip 200-3 may be substantially the same as the first semiconductor chip 200-1 of the semiconductor package 1000 of FIG. 1B, and the fourth semiconductor chip 200-4 may be substantially the same as the second semiconductor chip 200-2 of the semiconductor package 1000 of FIG. 1B. Accordingly, the third semiconductor chip 200-3 and the fourth semiconductor chip 200-4 may form a point-symmetrical structure with respect to each other. In addition, a connection relationship of the third semiconductor chip 200-3 and the fourth semiconductor chip 200-4 with the package substrate 100, and a connection relationship of the third semiconductor chip 200-3 and the fourth semiconductor chip 200-4 with the third chip stack structure 600 and the fourth chip stack structure 700 may be substantially the same as a connection relationship of the first semiconductor chip 200-1 and the second semiconductor chip 200-2 with the package substrate 100 and a connection relationship of the first semiconductor chip 200-1 and the second semiconductor chip 200-2 with the first chip stack structure 300 and the second chip stack structure 400 in the semiconductor package 1000 of FIG. 1B.

In the semiconductor package 1000e according to embodiments, the first semiconductor chip 200c-1 and the second semiconductor chip 200c-2 of the chip unit 200c may differ from the first semiconductor chip 200-1 and the second semiconductor chip 200-2 of the semiconductor package 1000 of FIG. 1B in terms of the structure of chip pads. In the semiconductor package 1000e according to embodiments, the first semiconductor chip 200c-1 and the second semiconductor chip 200c-2 may form a point-symmetrical structure with respect to each other. Therefore, the following description is made with respect to the first semiconductor chip 200c-1.

As shown in FIG. 7B, the left first chip pad 230-1 and the right first chip pad 220-1 of the first semiconductor chip 200c-1 may be substantially the same as the left first chip pad 230-1 and the right first chip pad 220-1 of the first semiconductor chip 200-1 of the semiconductor package 1000 of FIG. 1B. Accordingly, a connection structure between the left first chip pad 230-1 and the first chip stack structure 300, and a connection structure between the right first chip pad 220-1 and the upper substrate pad 120 of the package substrate 100 may be substantially the same as those in the semiconductor package 1000 of FIG. 1B.

Because the third semiconductor chip 200-3 may be stacked on the first semiconductor chip 200c-1, the central first chip pad 240a-1 may be disposed on a left edge in the X-direction. In other words, the left first chip pad 230-1 and the central first chip pad 240a-1 may be mixed and disposed on the left edge in the X-direction. As shown in FIG. 7A, the central first chip pad 240a-1 may be connected to a memory chip 310 positioned fifth from the bottom in the Z-direction in the first chip stack structure 300 through a second wire 330a. As the central first chip pad 240a-1 is disposed on the left edge of the first semiconductor chip 200c-1, the second wire 330a may be shorter than the second wire 330 of the semiconductor package 1000 of FIG. 1B.

As the third semiconductor chip 200-3 is stacked on the first semiconductor chip 200c-1, the right first chip pad 220-1 and the right third chip pad of the third semiconductor chip 200-3 may be commonly connected to the upper substrate pad 120 through the third wire 250. The left second chip pad of the second semiconductor chip 200c-2 and the left fourth chip pad of the fourth semiconductor chip 200-4 may also be commonly connected to the upper substrate pad 120 through the third wire 250. Accordingly, four chip pads may be connected to the upper substrate pad 120 with a single-point type common connection structure.

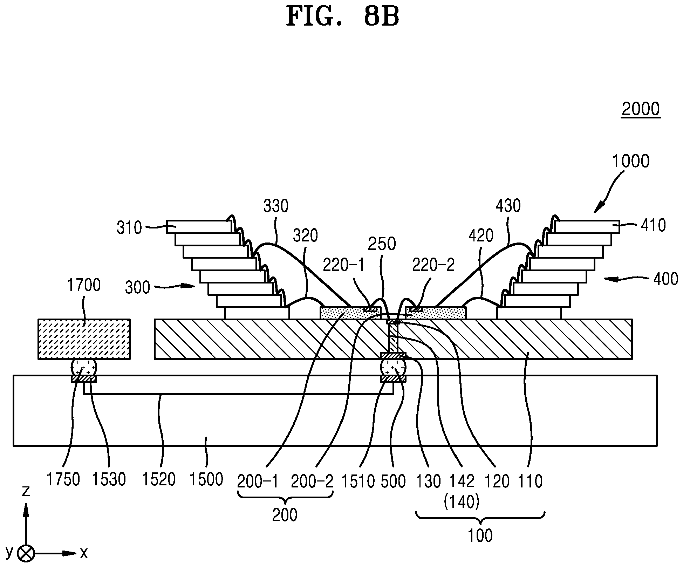

FIGS. 8A and 8B are a plan view and a cross-sectional view schematically showing a semiconductor package device 2000 including buffer chips, according to an embodiment. FIG. 8B is a cross-sectional view taken along line II-II' of FIG. 8A. Descriptions of FIGS. 8A and 8B which are redundant or duplicative of description given above with reference to FIGS. 1A through 7B may be given briefly or omitted herein.

Referring to FIGS. 8A and 8B, the semiconductor package device 2000 according to embodiments may include an internal semiconductor package 1000, an external package substrate 1500, and a controller chip 1700. The internal semiconductor package 1000 may be, for example, the semiconductor package 1000 of FIG. 1A. However, according to embodiments, the internal semiconductor package 1000 is not limited to the semiconductor package 1000 of FIG. 1A. For example, the internal semiconductor package 1000 may be any one of the semiconductor packages 1000a through 1000e of FIGS. 5A-7A.

The external package substrate 1500 may be disposed below the internal semiconductor package 1000 and the controller chip 1700 in the Z-direction, and may support the internal semiconductor package 1000 and the controller chip 1700. In the semiconductor package device 2000 according to embodiments, the external package substrate 1500 may be, for example, a PCB. However, according to embodiments, the external package substrate 1500 is not limited to a PCB. The external package substrate 1500 may have a similar structure to the package substrate 100 of the semiconductor package 1000 of FIG. 1A, but may be larger in size than the package substrate 100 of the semiconductor package 1000 of FIG. 1A. In addition, in some embodiments, other types of semiconductor chips and/or semiconductor packages, and passive elements may be further disposed on the external package substrate 1500, in addition to the internal semiconductor package 1000 and the controller chip 1700.

The controller chip 1700 may be disposed on the external package substrate 1500 to be adjacent to the internal semiconductor package 1000. The controller chip 1700 may be mounted on the external package substrate 1500 through a connection terminal 1750. In FIG. 8B, only one connection terminal 1750 is shown for a connection relationship. However, embodiments are not limited thereto, and in some embodiments a plurality of connection terminals 1750 may be disposed on a lower surface of the controller chip 1700. The controller chip 1700 may be connected to the external connection terminal 500 of the internal semiconductor package 1000 through wiring 1520 of the external package substrate 1500. The controller chip 1700 may generally control signal transmission to the internal semiconductor package 1000.

While some embodiments are particularly shown and described above, the scope of the disclosure is not limited thereto, and it will be understood that various changes in form and details may be made therein without departing from the scope of the following claims.

## Claims

1. A semiconductor package comprising:
a package substrate (100; 100a; 100b);
a chip unit (200; 200a; 200b; 200c) comprising a first semiconductor chip (200-1; 200a-1; 200b-1; 200c-1) on a left portion of the package substrate (100; 100a; 100b) in a first direction, and a second semiconductor chip (200-2; 200a-2; 200b-2; 200c-2) on a right portion of the package substrate (100; 100a; 100b) in the first direction;
a first chip stack structure (300) in which a first plurality of memory chips (310) are stacked, wherein the first chip stack structure (300) is leftward of the first semiconductor chip (200-1; 200a-1; 200b-1; 200c-1) in the first direction and adjacent to the first semiconductor chip (200-1; 200a-1; 200b-1; 200c-1) on the package substrate (100; 100a; 100b); and
a second chip stack structure (400) in which a second plurality of memory chips (410) are stacked, wherein the second chip stack structure (400) is rightward of the second semiconductor chip (200-2; 200a-2; 200b-2; 200c-2) in the first direction and adjacent to the second semiconductor chip (200-2; 200a-2; 200b-2; 200c-2) on the package substrate (100; 100a; 100b),
wherein the first semiconductor chip (200-1; 200a-1; 200b-1; 200c-1) comprises a first chip body (210-1; 210a-1), a left first chip pad (230-1; 230a-1; 230b-1) extending in a second direction perpendicular to the first direction along a left edge of an upper surface of the first chip body (210-1; 210a-1) in the first direction, and a right first chip pad (220-1; 220a-1) extending along a right edge of the upper surface of the first chip body (210-1; 210a-1) in the first direction,
wherein the second semiconductor chip (200-2; 200a-2; 200b-2; 200c-2) comprises a second chip body (210-2; 210a-2), a left second chip pad (220-2; 220a-2) extending in the second direction along a left edge of an upper surface of the second chip body (210-2; 210a-2) in the first direction, and a right second chip pad (230-2; 230a-2; 230b-2) extending in the second direction along a right edge of the upper surface of the second chip body (210-2; 210a-2) in the first direction,
wherein the left first chip pad (230-1; 230a-1; 230b-1) is connected to the first chip stack structure (300), and the right first chip pad (220-1; 220a-1) is connected to a substrate pad (120) included in the package substrate (100; 100a; 100b),
wherein the left second chip pad (220-2; 220a-2) is connected to the substrate pad (120), and the right second chip pad (230-2; 230a-2; 230b-2) is connected to the second chip stack structure (400),
wherein the right first chip pad (220-1; 220a-1) is symmetrical to the left second chip pad (220-2; 220a-2), and
wherein the right first chip pad (220-1; 220a-1) and the left second chip pad (220-2; 220a-2) are connected to the substrate pad (120) using a single-point type connection.

2. The semiconductor package of claim 1, wherein the right first chip pad (220-1) is point symmetrical to the left second chip pad (220-2), and
wherein each of the right first chip pad (220-1) and the left second chip pad (220-2) comprises a mirror pad (M).

3. The semiconductor package of claim 2, wherein the mirror pad (M) is configured to receive a swap enable signal, and
wherein a connection order in the second direction between the right first chip pad (220-1) and an internal circuit is opposite to a connection order in the second direction between the left second chip pad (220-2) and the internal circuit.

4. The semiconductor package of claim 1, wherein the right first chip pad (220a-1) is mirror symmetrical to the left second chip pad (220a-2), and
wherein an internal circuit of the first semiconductor chip (200a-1) is mirror symmetrical to an internal circuit of the second semiconductor chip (200a-2).

5. The semiconductor package of any one of claims 1 to 4, wherein the left first chip pad (230-1; 230a-1; 230b-1) is connected to the first chip stack structure (300) by a first wire (320; 320b),
wherein the right second chip pad (230-2; 230a-2; 230b-2) is connected to the second chip stack structure (400) by a second wire (420; 420b), and
wherein the right first chip pad (220-1; 220a-1) and the left second chip pad (220-2; 220a-2) are connected to the substrate pad (120) by a third wire (250).

6. The semiconductor package of claim 5, wherein the substrate pad (120) extends in the second direction along an upper surface of the package substrate (100a) between the first semiconductor chip (200-1) and the second semiconductor chip (200-2) in the first direction,
wherein a lower substrate pad (130) is on a lower surface of the package substrate (100a), and
wherein the substrate pad (120) is connected to the lower substrate pad (130) by at least one of an internal wire (144) included in the package substrate (100a) and a vertical via (142) penetrating through the package substrate (100).

7. The semiconductor package of any one of claims 1 to 6, wherein the first semiconductor chip (200-1) further comprises a central first chip pad (240-1) extending in the second direction between the left first chip pad (230-1) and the right first chip pad (230-1) in the first direction, and
wherein the second semiconductor chip (200-2) further comprises a central second chip pad (240-2) extending in the second direction between the left second chip pad (220-2) and the right second chip pad (230-2) in the first direction.

8. The semiconductor package of claim 7, wherein the central first chip pad (240-1) is connected to first upper memory chips on an upper portion of the first chip stack structure (300), and
wherein the central second chip pad (240-2) is connected to second upper memory chips on an upper portion of the second chip stack structure (400).

9. The semiconductor package of any one of claims 1 to 6, wherein the chip unit (200c) further comprises a third semiconductor chip (200-3) on the first semiconductor chip (200c-1), and a fourth semiconductor chip (200-4) on the second semiconductor chip (200c-2), and
wherein a right third chip pad of the third semiconductor chip (200-3) is symmetrical to a left fourth chip pad of the fourth semiconductor chip (200-4).

10. The semiconductor package of claim 9, further comprising a third chip stack structure (600) on the first chip stack structure (300), and a fourth chip stack structure (700) on the second chip stack structure (400),
wherein a left third chip pad of the third semiconductor chip (200-3) is connected to the third chip stack structure (600), and a right fourth chip pad of the fourth semiconductor chip (200-4) is connected to the fourth chip stack structure (700), and
wherein the right third chip pad and the left fourth chip pad are connected to the substrate pad (120) using the single-point type connection.

11. The semiconductor package of any one of claims 1 to 10, wherein the first semiconductor chip (200-1; 200a-1; 200b-1; 200c-1) and the second semiconductor chip (200-2; 200a-2; 200b-2; 200c-2) are buffer chips, and
wherein each memory chip from among the first plurality of memory chips (310) and the second plurality of memory chips (410) is a flash memory chip.

12. A semiconductor package device comprising:
an external package substrate (1500);
the semiconductor package (1000) according to any one of claims 1 to 11, wherein the semiconductor package (1000) is on the external package substrate (1500); and
a controller chip (1700) adjacent to the semiconductor package (1000) on the external package substrate (1500),
wherein the semiconductor package (1000) comprises an external connection terminal (500) on a lower surface of the package substrate (100).

13. The semiconductor package of claim 12, wherein the right first chip pad (220-1) of the first semiconductor chip (200-1) is point symmetrical to the left second chip pad (220-2) of the second semiconductor chip (200-2),
wherein each of the right first chip pad (220-1) of the first semiconductor chip (200-1) and the left second chip pad (220-2) of the second semiconductor chip (200-2) comprises a mirror pad (M) configured to receive a swap enable signal, and
wherein a connection order in the second direction between the right first chip pad (220-1) of the first semiconductor chip (200-1) and an internal circuit is opposite to a connection order in the second direction between the left second chip pad (220-2) of the second semiconductor chip (200-2) and the internal circuit.

14. The semiconductor package of claim 12 or 13, wherein the substrate pad (120) extends in the second direction on an upper surface of the package substrate (100) between the first semiconductor chip (200-1) and the second semiconductor chip (200-2) in the first direction,
wherein the package substrate (100) comprises a lower substrate pad (130) that is on the lower surface of the package substrate (100), and
wherein the lower substrate pad (130) is connected to the substrate pad (120) without branching, by at least one of an internal wire of the package substrate (100) and a vertical via (142) of the package substrate (100).

15. The semiconductor package of claim 14, wherein the external connection terminal (500) is on the lower substrate pad (130),
wherein the semiconductor package (1000) is mounted on the external package substrate (1500) through the external connection terminal (500), and
wherein the right first chip pad (220-1) of the first semiconductor chip (200-1) and the left second chip pad (220-2) of the second semiconductor chip (200-2) are connected to the controller chip (1700) by the external connection terminal (500) and a wire (1520) of the external package substrate (1500).
